# EUROPEAN PATENT SPECIFICATION

(11) **EP 0 558 149 B1**
(45) Date of publication and mention of the grant of the patent: **02.05.1997**
(21) Application number: 93200540.8
(22) Date of filing: 25.02.1993
(51) Int. Cl.: C08L 63/00, C08G 59/20, B32B 27/38

(54) **Epoxy resin and epoxy resin composition**
Epoxyharz und Epoxyharzzusammensetzung
Résine époxyde et composition de résine époxyde

(30) Priority: 27.02.1992 JP 75653/92
(43) Date of publication of application: 01.09.1993
(73) Proprietor: SHELL INTERNATIONALE RESEARCH MAATSCHAPPIJ B.V., 2596 HR Den Haag (NL)
(72) Inventor: Maeda, Kazuo, c/o Nishiazabu Mitsui Building, Minato-ku, Tokyo 106 (JP); Watanabe, Takamasa, c/o Nishiazabu Mitsui Building, Minato-ku, Tokyo 106 (JP); Fukuzawa, Takao, c/o Nishiazabu Mitsui Building, Minato-ku, Tokyo 106 (JP)

(56) References cited:
- EP-A- 0 549 080
- DE-A- 3 704 149
- US-A- 3 514 418
- DATABASE WPIL Week 8449, Derwent Publications Ltd., London, GB; AN 84-305021; & JP-A-59 191 786

## Description

The present invention relates to an epoxy resin and an epoxy resin composition comprising this epoxy resin. The epoxy resin composition of the invention can be advantageously used for the production of copper-clad epoxy resin laminates for printed circuit boards (PCB's), particularly multilayered PCB's, due to the ability to yield a cured product showing an improved combination of properties such as good heat resistance, good soldering heat resistance (measling resistance), good drillability, and good adhesion to metal.

Miniaturization of electronic machines and equipment has called for PCB's having improved heat resistance, moisture resistance, and measling resistance.

It is known in the art that the heat resistance of a cured epoxy resin composition can be improved by incorporating in said epoxy resin composition a polyfunctional epoxy resin such as for example a phenol novolak-type epoxy resin, a cresol novolak-type epoxy resin, a bisphenol A-type epoxy resin and a triglycidyletherified product of p-aminophenol.

A known epoxy resin composition having improved heat resistance is the reaction product of a polyfunctional epoxy resin selected from the ones mentioned above and a bisphenol A-type epoxy resin with a polyhydric phenolic compound. However the heat resistance of this cured epoxy resin composition still does not meet the current requirements, i.e. there is room for improvement in this respect.

Therefore, it is an object of the present invention to provide an epoxy resin and an epoxy resin composition comprising this epoxy resin, the latter being particularly useful, for the production of copper-clad epoxy resin laminates for PCB's, showing in the cured state in particular good heat resistance, good measling resistance, good drillability, and good adhesion to metal.

The present invention relates to an epoxy resin which is obtained by reacting an epoxy compound (a) with a polyhydric phenolic compound (b) in the presence of a catalyst, said epoxy compound (a) comprising a polyglycidyl ether compound which is obtained by reacting:
i) a mixture composed of a polyhydric phenolic compound (b') and at least one bisphenol compound selected from the group consisting of bisphenol A, bisphenol F, and tetrabromobisphenol A, said polyhydric phenolic compound (b') being at least one compound selected from the group consisting of a polyhydric phenolic compound (1) obtainable by reacting an aldehyde compound or ketone compound having a hydroxyl group-substituted phenyl group with a phenolic compound in the presence of an acid catalyst, a polyhydric phenolic compound (2) obtainable by reacting a phenol dimethylol compound or phenol novolak dimethylol compound with a phenolic compound in the presence of an acid catalyst, and a polyhydric phenolic compound (3) obtainable by reacting a phenolic compound with formaldehyde in the presence of an acid catalyst, with
ii) a compound represented by the general formula (A) 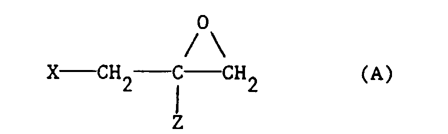 wherein X is a halogen atom and Z is a hydrogen atom or methyl group.

The present invention further relates to an epoxy resin composition comprising an epoxy resin as defined above, a hardener, an accelerator and a solvent.

The aldehyde compound or ketone compound used for the preparation of the polyhydric phenolic compound (1) may be selected from the group consisting of salicylaldehyde, p-hydroxybenzaldehyde and p-hydroxyacetophenone.

The phenol dimethylol compound used for the preparation of the polyhydric phenolic compound (2) may be selected from the group consisting of an o-cresol dimethylol compound, a m-cresol dimethylol compound, a p-cresol dimethylol compound and a dimethylol phenol compound.

The phenol novolak dimethylol compound used for the preparation of the polyhydric phenolic compound (2) may be selected from the group consisting of an o-cresol binuclear dimethylol compound, a m-cresol binuclear dimethylol compound, a p-cresol binuclear dimethylol compound and binuclear dimethylol compounds, which are represented by the general formula (B) 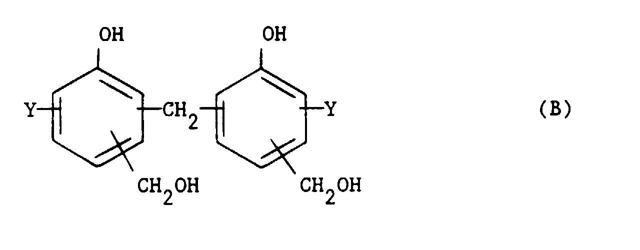 wherein each Y independently is a hydrogen atom or a methyl group.

The phenolic compound used for the preparation of the polyhydric phenolic compounds (1), (2) and (3) may be selected from the group consisting of phenol, o-cresol, m-cresol, p-cresol, p-(t-butyl)phenol and bisphenol A.

Glycidyl-etherification of the polyhydric phenolic compound (b')/bisphenol blend with the above compound of the above formula A may be carried out according to methods known in the art.

For the purpose of preparing the above polyglycidylether compound there are no restrictions to the mixing ratio of the polyhydric phenolic compound (b') and the bisphenol compound. However preferably the amount of the polyhydric phenolic compound (b') used is less than 50 wt% of the total amount (100 wt%) of its mixture with the bisphenol compound. Often if the amount of the polyhydric phenol compound (b') used is more than 50 wt%, the amount of polyfunctional epoxy resin in the polyglycidyl ether compound, gets to a level where, in the subsequent polymerization reaction with the polyhydric phenolic compound (b), excessive polymerization is likely to occur. The epoxy compound (a) preferably consists solely of the above polyglycidylether compound. However if desired the epoxy compound (a) may comprise less than 100 parts by weight, preferably less than 50 parts by weight, per 100 parts by weight of the polyglycidylether compound, of another epoxy compound.

Such other epoxy compounds are for example glycidyl ether-type epoxy resins such as bisphenol-type epoxy resins, phenol novolak-type epoxy resins and cresol novolak-type epoxy resins; glycidyl ester-type epoxy resins; glycidyl amine-type epoxy resins; linear aliphatic epoxy resins; alicyclic epoxy resins; heterocyclic epoxy resins; halogenated epoxy resins and other polyfunctional epoxy resins.

The polyhydric phenolic compound (b) may be selected from the group consisting of bisphenol A, bisphenol F, tetrabromobisphenol A and any of the polyhydric phenolic compounds (b') mentioned above.

These polyhydric phenolic compounds (b) may be used alone or in combination with one another.

The catalyst used in the reaction of epoxy compound (a) with polyhydric phenolic compound (b) may be selected from the group consisting of the imidazoles such as 1,2-dimethylimidazole and 2-methylimidazole; the amines such as trimethylamine and triethylamine; the ammonium salts such as tetramethyl ammonium bromide and tetramethyl ammonium chloride; the phosphines such as triphenylphosphine and the phosphonium salts such as benzyltriphenyl phosphonium chloride and ethyltriphenyl phosphonium bromide.

The above discussed prior art epoxy resin composition is prepared by reacting a polyhydric phenolic compound with a mixture of polyfunctional epoxy resin and bisphenol-type epoxy resin.

The two epoxy resins usually differ in reaction rate from each other, which may be the cause of their unsatisfactory performance when used in laminates for PCB's.

However, in case of the present invention the reaction between the epoxy compound (a) and the polyhydric phenolic compound (b) proceeds at a relatively uniform rate, thus giving an epoxy resin which yields a cured product having inter alia improved heat resistance.

The present invention further relates to an epoxy resin composition comprising the epoxy resin of the invention as discussed above, a hardener, an accelerator and a solvent. The epoxy resin composition may comprise the epoxy resin of the invention either as the only epoxy resin or in combination with another epoxy resin having two or more epoxy groups in one molecule such as for example glycidyl ether-type epoxy resins such as bisphenol A-type epoxy resins, phenol novolak-type epoxy resins and cresol novolak-type epoxy resins; glycidyl ester-type epoxy resins; glycidyl amine-type epoxy resins; linear aliphatic epoxy resins; alicyclic epoxy resins; heterocyclic epoxy resins; halogenated epoxy resins and other polyfunctional epoxy resins.

The additional epoxy resin(s) should be present in epoxy compound (a) in an amount of less than 50 wt%, based on the total amount (100 wt%) of the epoxy resin of the present invention and the other epoxy resin(s). The use of a higher amount, of the other epoxy resin(s) will negatively affect the performance of a laminate, prepared with an epoxy resin composition comprising such an epoxy resin (a).

The hardener, used in the epoxy resin composition of the present invention may be selected from the group consisting of the aromatic polyamines, dicyandiamide, the acid anhydrides and the phenol novolak resins.

The accelerator used in the epoxy resin composition of the present invention may be selected from the group consisting of the amines such as benzyldimethylamine and imidazole compounds and the tertiary phosphines such as triphenylphosphine.

The solvent used in the epoxy resin composition of the present invention may be selected from the group consisting of acetone, methyl ethyl ketone, toluene, xylene, methyl isobutyl ketone, ethyl acetate, ethylene glycol monomethyl ether, N,N-dimethylformamide, N,N-dimethylacetamide, methanol and ethanol. These solvents may be used alone or in combination with one another.

If desired the epoxy resin composition of the present invention may comprise further additives, such as for example flame retardants and fillers.

The process for the preparation of copper-clad epoxy resin laminates comprising the epoxy resin composition of the present invention may be carried out according to any method known in the art. Essentially the process comprises the steps of impregnating a glass cloth with the epoxy resin composition, making a prepreg by drying and heating for solvent removal, placing a copper foil on one side or both sides of a single prepreg or of two or more layered prepregs, and pressing the assembly in the usual manner, while heating and thereby forming a laminate.

The following examples serve to illustrate the present invention. In the Examples and Comparative Examples, "parts" and "%" mean "parts by weight" and "wt%", respectively.

### Example 1

### Synthesis of polyglycidyl ether compounds

(I) A glass vessel equipped with a stirrer was charged with 564 g of phenol, 112 g of salicylaldehyde, and 0.3 g of conc. hydrochloric acid. Reaction was carried out at 100 °C for 30 minutes. Next 0.5 g of p-toluenesulfonic acid was added and the reactants were heated to 180 °C, and reaction was carried out at 180 °C for 2 hours, during which excess phenol was removed by distillation. After completion of reaction, the reaction product was dissolved in 500 g of methyl isobutyl ketone. The solution was washed with 1000 g of 3% aqueous solution of NaHCO₃ and next with 1000 g of distilled water to remove the catalyst. The solution was freed of methyl isobutyl ketone and residual phenol under reduced pressure. Thus 260 g of a polyphenol was obtained.
   Subsequently, a glass vessel equipped with a stirrer was charged with 10 g of the just prepared polyphenol, 103 g of bisphenol A, and 395 g of epichlorohydrin. The reactants were heated from 30 °C to 50 °C at a rate of 1 °C/3 minutes. While heating, a 48.5 % aqueous solution of NaOH was added dropwise at a rate of 1 g/2 minutes. Reaction was carried out at 50 °C for 60 minutes. After the completion of reaction, the reaction product was freed of unreacted epichlorohydrin under reduced pressure and then washed with water. 165 g of a polyglycidyl ether compound ("Epoxy resin (I)"), having an epoxy equivalent of 185 g/eq, was thus obtained.
(II) A glass vessel equipped with a stirrer was charged with 168 g of 2,4-bishydroxymethyl-o-cresol, 324 g of o-cresol, and 2 g of oxalic acid. Reaction was carried out at 75 °C for 4 hours. The reaction product underwent dehydration under reduced pressure and steam distillation. 330 g polyphenol was thus obtained.
   Subsequently, 23 g of the polyphenol just prepared and 91 g of bisphenol A were reacted with epichlorohydrin and the reaction product underwent post treatment in the same manner as in (I). 167 g of a polyglycidyl ether compound ("Epoxy resin (II)"), having an epoxy equivalent of 188 g/eq, was thus obtained.
(III) A polyphenol was prepared by means of the reaction and post treatment as in (II) except for the use of 290 g of bis (2-hydroxy-5-hydroxymethyl-3-methylphenyl)methane instead of 168 g of 2,4-bishydroxymethyl-o-cresol. 440 g of a polyphenol was thus obtained.
   Subsequently, 24 g of the polyphenol just prepared and 80 g of bisphenol F were reacted with epichlorohydrin and the reaction product was post treated in the same manner as in (I). 155 g of a polyglycidyl ether compound ("Epoxy resin (III)"), having an epoxy equivalent of 177 g/eq, was thus obtained.
(IV) A glass vessel equipped with a stirrer was charged with 228 g of bisphenol A, 61 g of 37% formalin, and 1.3 g of oxalic acid. Reaction was carried out at 130 °C for 3 hours. The reaction product underwent dehydration under reduced pressure. 240 g of a polyphenol was thus obtained.

Subsequently, 35 g of the polyphenol just prepared and 80 g of bisphenol A were reacted with epichlorohydrin and the reaction product underwent post treatment in the same manner as in (I). 167 g of polyglycidyl ether compound ("Epoxy resin (IV)"), having an epoxy equivalent of 190 g/eq, was thus obtained.
(I') 98 g of the polyphenol prepared in (I) was reacted with epichlorohydrin and the reaction product underwent post treatment in the same manner as in (I). 150 g of polyglycidyl-etherified product ("Epoxy resin (I')"), having an epoxy equivalent of 168 g/eq, was thus obtained.
(II') 116 g of the polyphenol obtained in (II) was reacted with epichlorohydrin and the reaction product underwent post treatment in the same manner as (I). 169 g of polyglycidyl-etherified product ("Epoxy resin (II')"), having an epoxy equivalent of 190 g/eq, was thus obtained.
(III') 118 g of the polyphenol obtained in (III) was reacted with epichlorohydrin and the reaction product underwent post treatment in the same manner as in (I). 170 g of polyglycidyl-etherified product ("Epoxy resin (III')"), having an epoxy equivalent of 195 g/eq, was thus obtained.
(IV') 118 g of the polyphenol obtained in (IV) was reacted with epichlorohydrin and the reaction product underwent post treatment in the same manner as in (I). 167 g of polyglycidyl-etherified product ("Epoxy resin (IV')"), having an epoxy equivalent of 193 g/eq, was thus obtained.

### Example 2

### Preparation of epoxy resins according to the invention

(1) 66 Parts of Epoxy resin (I) and 34 parts of tetrabromophenol A were reacted in the presence of 0.03 part of 1,2-dimethylimidazole as a catalyst, for 3 hours at 150 °C. An epoxy resin (1), having an epoxy equivalent of 435 g/eq, was thus obtained.
(2) 66 Parts of Epoxy resin (II) and 34 parts of tetrabromophenol A were reacted in the same manner as in (1). An epoxy resin (2), having an epoxy equivalent of 452 g/eq, was thus obtained.
(3) 66 Parts of Epoxy resin (III) and 34 parts of tetrabromophenol A were reacted in the same manner as in (1). An epoxy resin (3) having an epoxy equivalent of 407 g/eq, was thus obtained.
(4) 66 Parts of Epoxy resin (IV) and 34 parts of tetrabromophenol A were reacted in the same manner as in (1). An epoxy resin (4), having an epoxy equivalent of 453 g/eq, was thus prepared.

### Example 3

### Preparation of comparative epoxy resins

(1') 10 Parts of Epoxy resin (I'), 56 parts of "Epikote 828", a bisphenol A-type epoxy resin having an epoxy equivalent of 187 g/eq (Epikote is a tradename) and 34 parts of tetrabromophenol A were reacted for 3 hours at 150 °C in the presence of 0.03 part of 1,2-dimethylimidazole as a catalyst. An epoxy resin (1') having an epoxy equivalent of 432 g/eq was thus prepared.
(2') 20 Parts of Epoxy resin (II'), 46 parts of "Epikote 828" and 34 parts of tetrabromophenol A were reacted in the same manner as in (1'). An epoxy resin (2') having an epoxy equivalent of 448 g/eq was thus obtained.
(3') 20 Parts of Epoxy resin (III'), 46 parts of "Epikote 807", a bisphenol-type epoxy resin having an epoxy equivalent of 170 g/eq and 34 parts of tetrabromophenol A were reacted in the same manner as in (1'). An epoxy resin (3') having an epoxy equivalent of 408 g/eq, was thus obtained.
(4') 30 Parts of Epoxy resin (IV'), 36 parts of Epikote 828 and 34 parts of tetrabromophenol A were reacted in the same manner as in (1'). An epoxy resin (4') having an epoxy equivalent of 453 g/eq was thus obtained.
(5') 10 Parts of Epoxy resin (I') were mixed with 90 parts of Epikote 5049, a brominated bisphenol-type epoxy resin having an epoxy equivalent of 748 g/eq and containing 28% bromine. This blend will be referred to as epoxy resin (5').
(6') 20 Parts of Epoxy resin (II') were mixed with 80 parts "Epikote 5049". This blend will be referred to as epoxy resin (6').

### Example 4

### Preparation of epoxy resin compositions according to the invention and for comparison and of laminates comprising said compositions

100 Parts of one of the epoxy resins (1) to (4) and (1') to (6'), 3 parts of dicyandiamide and 0.15 part of 2-ethyl-4-methylimidazole were blended with a 1:1 (by weight) solvent blend of methyl ethyl ketone and ethylene glycol monomethyl ether, to give an epoxy resin composition (varnish) having a solids content of 55%.

Subsequently, a glass cloth was impregnated with this varnish. After drying at 130 °C for 7 minutes, a prepreg containing 45% epoxy resin composition was obtained. Eight sheets of the prepreg were stacked and 35 µm thick copper foils were placed on both sides of the layered prepregs. The assembly was pressed at 170 °C and 40 kg/cm² for 1 hour. Thus a 1.6-mm thick copper-clad glass-epoxy laminate was obtained.

Laminates 1 to 4 were prepared with epoxy resins (1) to (4) respectively according to the invention. Laminates 1' to 6' were prepared with epoxy resins (1') to (6') respectively for comparison.

Table 1 shows the characteristic properties of each cured laminate. It can be derived therefrom that cured laminates comprising an epoxy resin composition according to the invention have an excellent combination of good heat resistance, measling resistance, drillability and adhesion to copper foil.

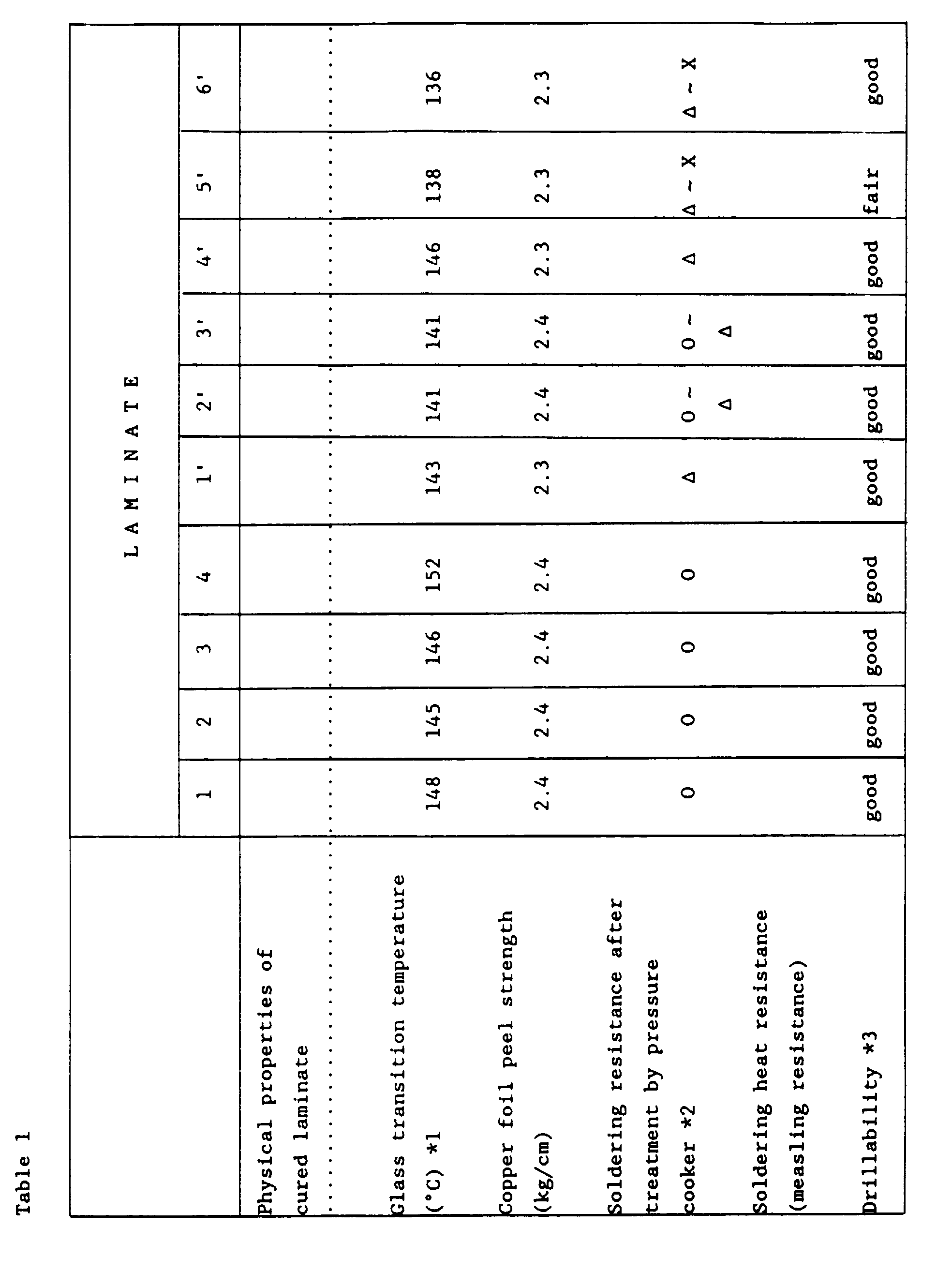

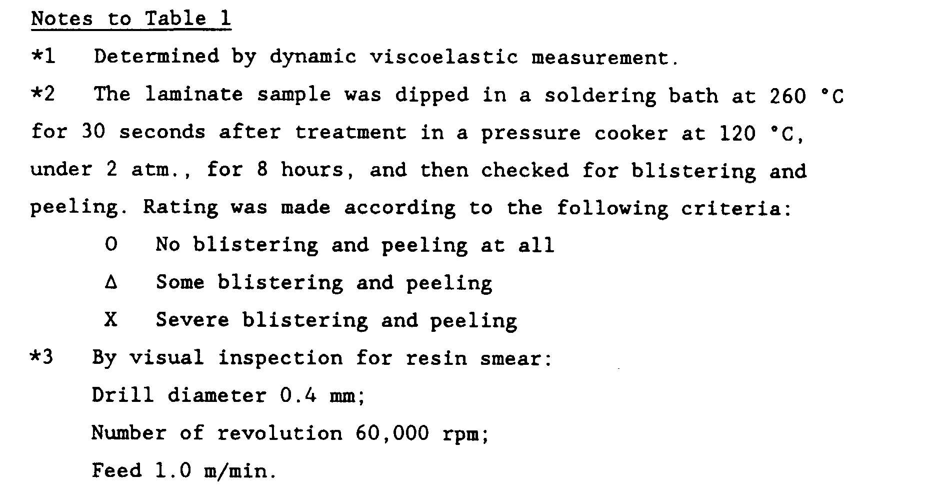

## Claims

1. An epoxy resin which is obtainable by reacting an epoxy compound (a) with a polyhydric phenolic compound (b) in the presence of a catalyst, said epoxy compound (a) comprising a polyglycidyl ether compound which is obtainable by reacting:
i) a mixture composed of a polyhydric phenolic compound (b') and at least one bisphenol compound selected from the group consisting of bisphenol A, bisphenol F and tetrabromobisphenol A, said polyhydric phenolic compound (b') being at least one compound selected from the group consisting of a polyhydric phenolic compound (1) obtainable by reacting an aldehyde compound or ketone compound having hydroxyl group-substituted phenyl group with a phenolic compound in the presence of an acid catalyst, a polyhydric phenolic compound (2) obtainable by reacting a phenol dimethylol compound or phenol novolak dimethylol compound with a phenolic compound in the presence of an acid catalyst, and a polyhydric phenolic compound (3) obtainable by reacting a phenolic compound with formaldehyde in the presence of an acid catalyst, with
ii) a compound represented by the general formula (A) 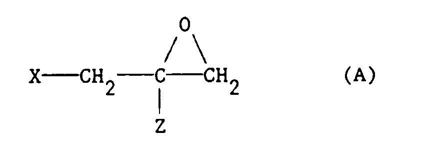 wherein X is a halogen atom and Z is a hydrogen atom or methyl group.

2. An epoxy resin composition as claimed in claim 1 wherein the aldehyde- or ketone compound used for the preparation of polyfunctional phenolic compound (1) is selected from the group consisting of salicylaldehyde, p-hydroxybenzaldehyde and p-hydroxy acetophenone.

3. An epoxy resin composition as claimed in claim 1, wherein the phenol dimethylol compound or the phenol novolak dimethylol compound used for the preparation of polyfunctional phenolic compound (2) is selected from the group consisting of an o-cresol dimethylol compound, a m-cresol dimethylol compound, a p-cresol dimethylol compound, a dimethylol phenol compound, a o-cresol binuclear dimethylol compound, a p-cresol binuclear dimethylol compound and binuclear dimethylol compounds represented by the general formula (B) 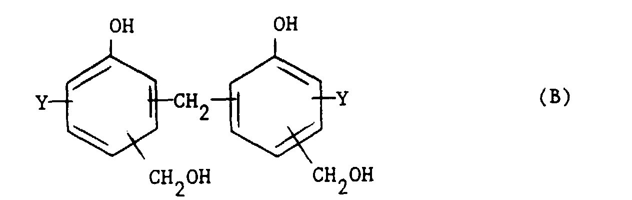 wherein each Y is independently H or CH₃.

4. An epoxy resin composition as claimed in any one of the claims 1 to 3 wherein the phenolic compound used for the preparation of each of the polyfunctional phenolic compounds (1), (2) and (3) is selected from the group consisting of phenol, o-cresol, m-cresol, p-cresol p-(t-butyl)-phenol and bisphenol A.

5. An epoxy resin as claimed in any one of the claims 1 to 4 wherein compound (a) solely consists of the polyglycidylether compound.

6. An epoxy resin as claimed in any one of the claims 1 to 5 wherein compound (a) comprises an other epoxy compound in an amount of less than 50% by weight, based on the total amount of the polyglycidylether compound and this other epoxy compound, said other epoxy compound being selected from the group consisting of glycidylether type epoxy resins such as bisphenol type epoxy resins, phenol novolak type epoxy resins and cresol novolak type epoxy resins; glycidyl ester type epoxy resins; glycidyl amine type epoxy resins; linear aliphatic epoxy resins; alicyclic epoxy resins; heterocyclic epoxy resins and halogenated epoxy resins.

7. An epoxy resin as claimed in any one of the claims 1 to 6 wherein the polyhydric phenolic compound (b) is selected from the group consisting of bisphenol A, bisphenol F, tetrabromobisphenol A, and any one of the polyhyric phenolic compounds (b') as claimed in any one of the claims 1 to 4.

8. An epoxy resin as claimed in any one of the claims 1 to 7 wherein the catalyst is selected from the group consisting of the imidazoles, the ammonium salts, the phosphines, and the phosphonium salts.

9. An epoxy resin composition comprising an epoxy resin as claimed in any one of the claims 1 to 8, a hardener, an accelerator and a solvent.

10. A laminate comprising a composition as claimed in claim 9 applied to a glass cloth and subsequently curing said composition.

## Patentansprüche

1. Durch Umsetzen einer Epoxyverbindung (a) mit einer mehrwertigen Phenolverbindung (b) in Anwesenheit eines Katalysators erhältliches Epoxyharz, welche Epoxyverbindung (a) eine Polyglycidyletherverbindung umfaßt, die erhältlich ist durch Umsetzen von:
i) einem aus einer mehrwertigen Phenolverbindung (b') und wenigstens einer Bisphenolverbindung, ausgewählt aus der aus Bisphenol A, Bisphenol F und Tetrabrombisphenol A bestehenden Gruppe, zusammengesetzten Gemisch, wobei die mehrwertige Phenolverbindung (b') wenigstens eine Verbindung ist, ausgewählt aus der aus einer mehrwertigen Phenolverbindung (1), erhältlich durch Umsetzen einer Aldehydverbindung oder Ketonverbindung, die eine Hydroxylgruppen-substituierte Phenylgruppe aufweist, mit einer Phenolverbindung in Gegenwart eines sauren Katalysators, eine mehrwertige Phenolverbindung (2), erhältlich durch Umsetzen einer Phenol-Dimethylolverbindung oder Phenol-Novolak-Dimethylolverbindung mit einer Phenolverbindung in Anwesenheit eines sauren Katalysators, und einer mehrwertigen Phenolverbindung (3), erhältlich durch Umsetzen einer Phenolverbindung mit Formaldehyd in Anwesenheit eines sauren Katalysators, mit:
ii) einer durch die allgemeine Formel (A) 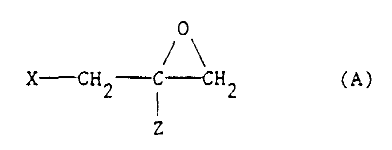 dargestellten Verbindung, worin X ein Halogenatom bedeutet und Z ein Wasserstoffatom oder die Methylgruppe darstellt.

2. Epoxyharzzusammensetzung nach Anspruch 1, worin die Aldehyd- oder Ketonverbindung, die zur Herstellung der mehrwertigen Phenolverbindung (1) verwendet wird, aus der aus Salicylaldehyd, p-Hydroxybenzaldehyd und p-Hydroxyacetophenon bestehenden Gruppe ausgewählt wird.

3. Epoxyharzzusammensetzung nach Anspruch 1, worin die zur Herstellung der mehrwertigen Phenolverbindung (2) verwendete Phenoldimethylolverbindung oder Phenol-Novolak-Dimethylolverbindung aus der Gruppe ausgewählt ist, die aus einer o-Cresoldimethylolverbindung, einer m-Cresoldimethylolverbindung, einer p-Cresoldimethylolverbindung, einer Dimethylolverbindung, einer o-Cresol-zweikernigen-Dimethylolverbindung, einer p-Cresol-zweikernigen-Dimethylolverbindung und aus zweikerningen Dimethylolverbindungen besteht, die durch die allgemeine Formel (B): 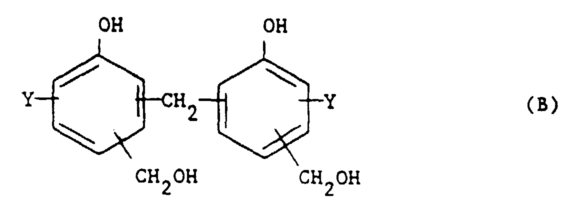 dargestellt werden, worin jedes Y unabhängig voneinander ein Wasserstoffatom oder eine Methylgruppe bedeutet.

4. Epoxyharzzusammensetzung nach einem der Ansprüche 1 bis 3, worin die zur Herstellung jeder der mehrwertigen Phenolverbindungen (1), (2) und (3) verwendete Phenolverbindung aus der aus Phenol, o-Cresol, m-Cresol, p-Cresol, p-(t.Butyl)-phenol und Bisphenol A bestehenden Gruppe ausgewählt ist.

5. Epoxyharz nach einem der Ansprüche 1 bis 4, worin die Verbindung (a) nur aus der Polyglycidetherverbindung besteht.

6. Epoxyharz nach einem der Ansprüche 1 bis 5, worin die Verbindung (a) eine andere Epoxyverbindung in einer Menge von weniger als 50 Gew.-%, bezogen auf die Gesamtmenge aus der Polyglycidyletherverbindung und dieser anderen Epoxyverbindung, umfaßt, worin diese andere Epoxyverbindung aus der Gruppe ausgewählt ist, die aus Epoxyharzen vom Glycidylether-Typ, wie Epoxyharze vom Bisphenoltyp, Epoxyharze vom Phenol-Novolak-Typ und Epoxyharze vom Cresol-Novolak-Typ; Epoxyharzen vom Glycidylester-Typ; Epoxyharzen vom Glycidylamin-Typ; linearen aliphatischen Epoxyharzen; alicyclischen Epoxyharzen; heterocyclischen Epoxyharzen und halogenierten Epoxyharzen besteht.

7. Epoxyharz nach einem der Ansprüche 1 bis 6, worin die mehrwertige Phenolverbindung (b) aus der Gruppe ausgewählt ist, die aus Bisphenol A, Bisphenol F, Tetrabrombisphenol A und einer der mehrwertigen phenolischen Verbindungen (b'), wie in einem der Ansprüche 1 bis 4 beansprucht, besteht.

8. Epoxyharz nach einem der Ansprüche 1 bis 7, worin der Katalysator aus der aus Imidazolen, Ammoniumsalzen, Phosphinen und Phosphoniumsalzen bestehenden Gruppe ausgewählt ist.

9. Epoxyharzzusammensetzung, umfassend ein Epoxyharz nach einem der Ansprüche 1 bis 8, einen Härter, einen Beschleuniger und ein Lösungsmittel.

10. Laminat, umfassend eine auf ein Glasgewebe aufgebrachte Zusammensetzung nach Anspruch 9, welche Zusammensetzung anschließend gehärtet worden ist.

## Revendications

1. Résine époxy que l'on obtient en faisant réagir un composé époxy (a) avec un composé phénolique polyhydroxylé (b), en présence d'un catalyseur, ledit composé époxy (a) comprenant une composé d'éther polyglycidylique, que l'on obtient en faisant réagir :
i) un mélange composé d'un composé phénolique polyhydroxylé (b') et d'au moins un composé du bisphénol, choisi dans le groupe formé par le bisphénol-A, le bisphénol-F et le tétrabromobisphénol-A, ledit composé phénolique polyhydroxylé (b') étant au moins un composé choisi dans le groupe formé par un composé phénolique polyhydroxylé (1) pouvant être obtenu par la réaction d'un composé du type aldéhyde ou d'une composé du type cétone, possédant un groupe phényle, à substitution hydroxyle, avec un composé phénolique, en présence d'un catalyseur acide, un composé phénolique polyhydroxylé (2) pouvant être obtenu par la réaction d'un composé du type phénoldiméthylol ou d'un composé du type phénol-novolaque-diméthylol avec un composé phénolique, en présence d'un catalyseur acide et un composé phénolique polyhydroxylé (3) pouvant être obtenu par la réaction d'un composé phénolique avec le formaldéhyde, en présence d'un catalyseur acide, avec
ii) un composé représenté par la formule générale (A) 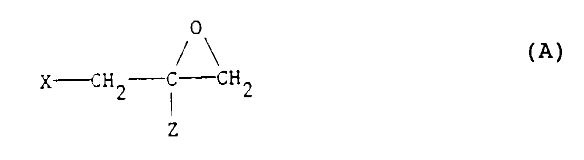 dans laquelle X représente un atome d'halogène et Z représente un atome d'hydrogène ou le radical méthyle.

2. Composition de résine époxy suivant la revendication 1, caractérisée en ce que le composé du type aldéhyde ou le composé du type cétone, utilisé pour la préparation du composé phénolique polyfonctionnel (1) est choisi dans le groupe formé par le salicylaldéhyde, le p-hydroxybenzaldéhyde et la p-hydroxyacétophénone.

3. Composition de résine époxy suivant la revendication 1, caractérisée en ce que le composé de phénoldiméthylol ou le composé de phénol-novolaque-diméthylol utilisé pour la préparation du composé phénolique polyfonctionnel (2) est choisi dans le groupe formé d'un composé diméthylolique de o-crésol, d'un composé diméthylolique de m-crésol, d'un composé diméthylolique de p-crésol, d'un composé diméthylolique de phénol, d'un composé diméthylolique de o-crésol binucléaire, d'un composé diméthylolique de p-crésol binucléaire et des composés diméthyloliques binucléaires, que l'on représente par la formule générale (B) 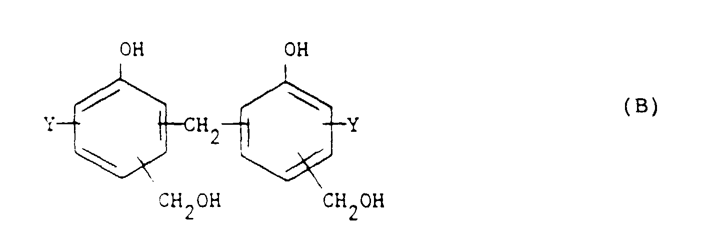 dans laquelle chaque symbole Y représente indépendamment un atome d'hydrogène ou un radical méthyle.

4. Composition de résine époxy suivant l'une quelconque des revendications 1 à 3, caractérisée en ce que le composé phénolique utilisé pour la préparation de chacun des composés phénoliques polyfonctionnels (1, (2) et (3) est choisi dans le groupe formé par le phénol, le o-crésol, le m-crésol, le p-crésol, le p-(t-butyl)phénol et le bisphénol-A.

5. Résine époxy suivant l'une quelconque des revendications 1 à 4, caractérisée en ce que le composé (a) est uniquement constitué du composé du type éther polyglycidylique.

6. Résine époxy suivant l'une quelconque des revendications 1 à 5, caractérisée en ce que le composé (a) comprend un autre composé époxy, en une proportion inférieure à 50% en poids, sur base de la quantité totale du composé du type éther polyglycidylique et de cet autre composé époxy, ledit autre composé époxy étant choisi dans le groupe formé par les résines du type éther glycidylique, comme les résines époxy du type bisphénol, les résines époxy du type phénol-novolaque et les résines époxy du type crésol-novolaque, les résines époxy du type ester glycidylique, les résines époxy du type glycidylamine, les résines époxy aliphatiques linéaires, les résines époxy alicycliques, les résines époxy hétérocycliques et les résines époxy halogénées.

7. Résine époxy suivant l'une quelconque des revendications 1 à 6, caractérisée en ce que l'on choisit le composé phénolique polyhydroxylé (b) dans le groupe formé par le bisphénol-A, le bisphénol-F, le tétrabromobisphénol-A et n'importe lesquels des composés phénoliques polyhydroxylés (b'), tels que revendiqués dans l'une quelconque des revendications 1 à 4.

8. Résine époxy suivant l'une quelconque des revendications 1 à 7, caractérisée en ce que l'on choisit le catalyseur dans le groupe formé par les imidazoles, les sels d'ammonium, les phosphines et les sels de phosphonium.

9. Composition de résine époxy comprenant une résine époxy suivant l'une quelconque des revendications 1 à 8, un durcisseur, un accélérateur et un solvant.

10. Lamifié ou stratifié comprenant une composition suivant la revendication 9, appliquée sur un tissu de verre et obtenu par le durcissement subséquent de cette composition.
